# EUROPEAN PATENT APPLICATION

(11) **EP 2 683 229 A2**
(43) Date of publication of application: **08.01.2014**
(21) Application number: 13172291.0
(22) Date of filing: 17.06.2013
(51) Int. Cl.: H05K 9/00

(54) **Electronic component box for vehicle**

(30) Priority: 05.07.2012 KR 20120073174
(71) Applicant: LSIS Co., Ltd., Dongan-gu, Anyang-si Gyeonggi-do 431-080 (KR)
(72) Inventor: Moon, Ki Young, 431-080 Anyang-si, Gyeonggi-do (KR); Kim, Young Min, 431-080 Anyang-si, Gyeonggi-do (KR); Kim, Hyoung Taek, 431-080 Anyang-si, Gyeonggi-do (KR)
(74) Representative: Lang, Johannes

(57) **Abstract**

Provided is an electronic component box for a vehicle. The electronic component box for a vehicle, the electronic component box including a housing formed of a plastic material and manufactured through plastic injection molding, the housing having an opened top surface, a top cover formed of a plastic material and manufactured through the plastic injection molding, the top cover covering the opened top surface of the housing, a base cover seated on a bottom surface of the housing, an electronic component set seated on a top surface of the base cover, and a plated layer disposed on an inner circumferential surface of the housing and a back surface of the top cover to shield an electromagnetic wave.

## Description

### CROSS-REFERENCE TO RELATED APPLICATIONS

The present application claims the benefits of priority to Korean Patent Application No. 10-2012-0073174 (filed on July 5, 2012), which is herein incorporated by reference in its entirety.

### BACKGROUND

The present disclosure relates to an electronic component box for vehicles.

Recently, technologies with respect to electric vehicles driven by using electricity that is green energy are being rapidly developed. Most of electric vehicles include a motor generating torque, a battery supplying a power to the motor, an inverter controlling the number of revolution of the motor, a battery charger charging electricity into the battery, and a low voltage DC/DC converter for vehicles.

The electronic components generate a large amount of heat and a lot of electromagnetic waves or noises that have an influence on operations of other electronic components during the operation thereof. To solve the above-described limitations, the electronic compounds are accommodated within an electronic compound box that has an air cooling type or water cooling type heat-dissipation structure and a shield function shielding EMI electromagnetic waves to satisfy electro magnetic compatibility (EMC).

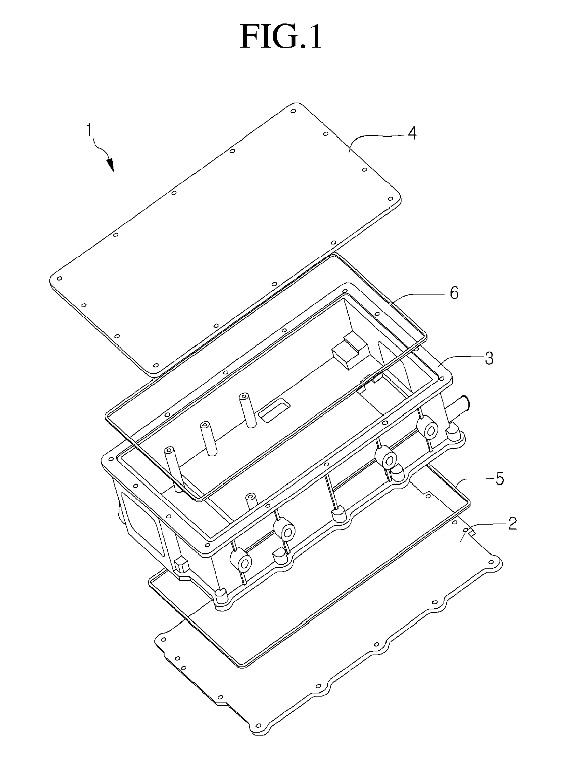

Fig. 1 is an exploded perspective view of an electronic component box for a vehicle according to a related art.

Referring to Fig. 1, an electronic component box 1 for a vehicle according to the related art includes a bottom cover 2 having a cooling passage in a top surface thereof, a housing 3 fixed to the top surface of the bottom cover 2 to accommodate all sorts of electronic components therein, a top cover 4 covering an opened top surface of the housing, an upper sealer 6 disposed between contact portions of the top cover 4 and the housing 3 to perform a sealing function, and a lower sealer 5 disposed between contact portions of the bottom cover 2 and the housing 3 to perform a sealing function.

The above-described electronic component box according to the related art adopts a water cooling type heat-dissipation method. Here, a cooling passage through which coolant flows is defined in an outer bottom surface of the housing 3 by the bottom cover 2.

Also, the housing 3 and top cover 4 is formed of a steel plate cold commercial (SPCC) or aluminum steel to shield the electromagnetic waves to improve cooling efficient and EMS stability.

However, in the case of the electronic component box product according to the related art, since the housing shielding the electronic components are formed of metallic materials including iron or aluminum to increase a weight of the electronic component box and reduce fabricating price competitiveness. Furthermore, when the electronic component box is increased in weight, a self-weight of the vehicle is increased to increase an electrical energy consumption.

### SUMMARY

Embodiments provide an electronic component box for a vehicle of which a self-weight decreases, but cooling efficiency and electromagnetic wave shielding function are maintained or improved.

Embodiments also provide an electronic component box for a vehicle. The electronic component box including: a housing formed of a plastic material and manufactured through plastic injection molding, the housing having an opened top surface; a top cover formed of a plastic material and manufactured through the plastic injection molding, the top cover covering the opened top surface of the housing; a base cover seated on a bottom surface of the housing; an electronic component set seated on a top surface of the base cover; and a plated layer disposed on an inner circumferential surface of the housing and a back surface of the top cover to shield an electromagnetic wave.

The details of one or more embodiments are set forth in the accompanying drawings and the description below. Other features will be apparent from the description and drawings, and from the claims.

### BRIEF DESCRIPTION OF THE DRAWINGS

Fig. 1 is an exploded perspective view of an electronic component box for a vehicle according to a related art.

Fig. 2 is a perspective view illustrating an outer appearance of an electronic component box according to an embodiment.

Fig. 3 is an exploded perspective view of the electronic component box.

Fig. 4 is a bottom view of a base cover disposed within the electronic component box.

Fig. 5 is a cross-sectional view taken along line I-I' of Fig. 2.

Fig. 6 is a cross-sectional view taken along line II-II' of Fig. 2.

### DETAILED DESCRIPTION OF THE EMBODIMENTS

In the following detailed description of the preferred embodiments, reference is made to the accompanying drawings that form a part hereof, and in which is shown by way of illustration specific preferred embodiments in which the invention may be practiced. These embodiments are described in sufficient detail to enable those skilled in the art to practice the invention, and it is understood that other embodiments may be utilized and that logical structural, mechanical, electrical, and chemical changes may be made without departing from the spirit or scope of the invention. To avoid detail not necessary to enable those skilled in the art to practice the invention, the description may omit certain information known to those skilled in the art. The following detailed description is, therefore, not to be taken in a limiting sense, and the scope of the present invention is defined only by the appended claims.

Hereinafter, an electronic component box for a vehicle, particularly, an electrical vehicle according to embodiments will be described in detail with reference to the accompanying drawings.

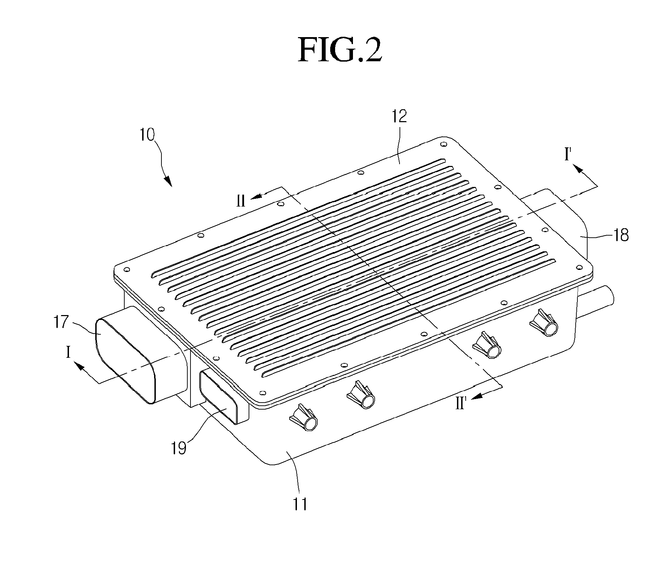

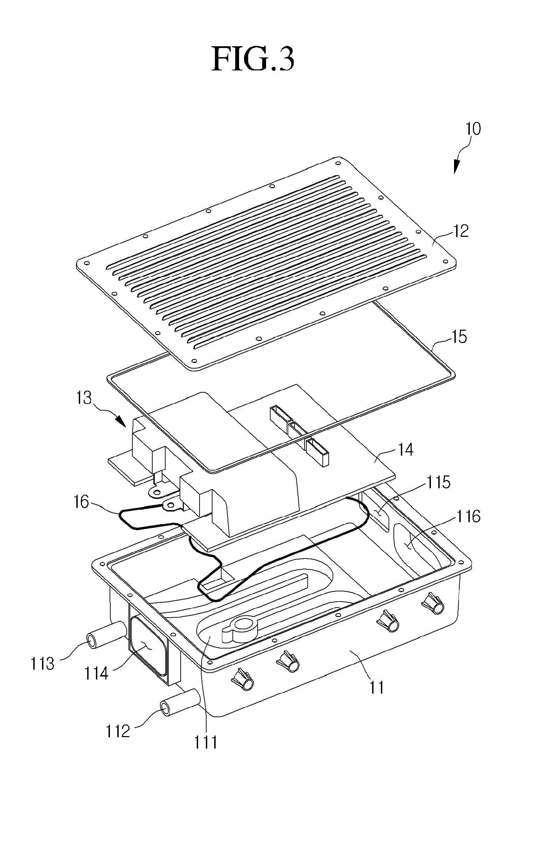

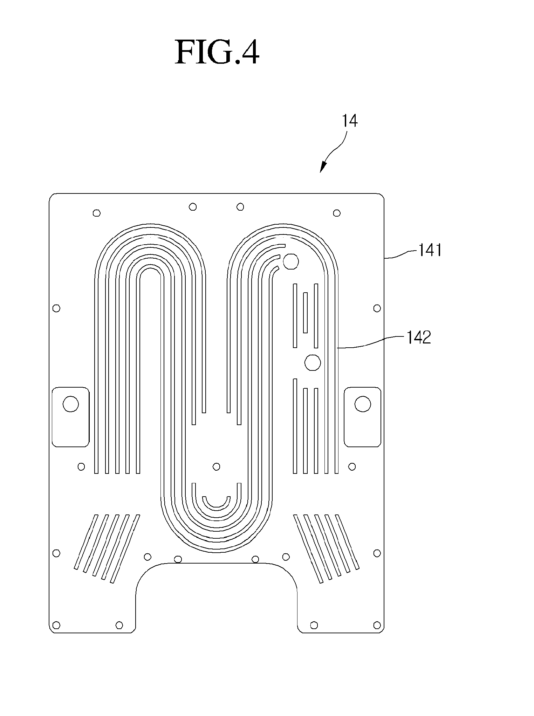

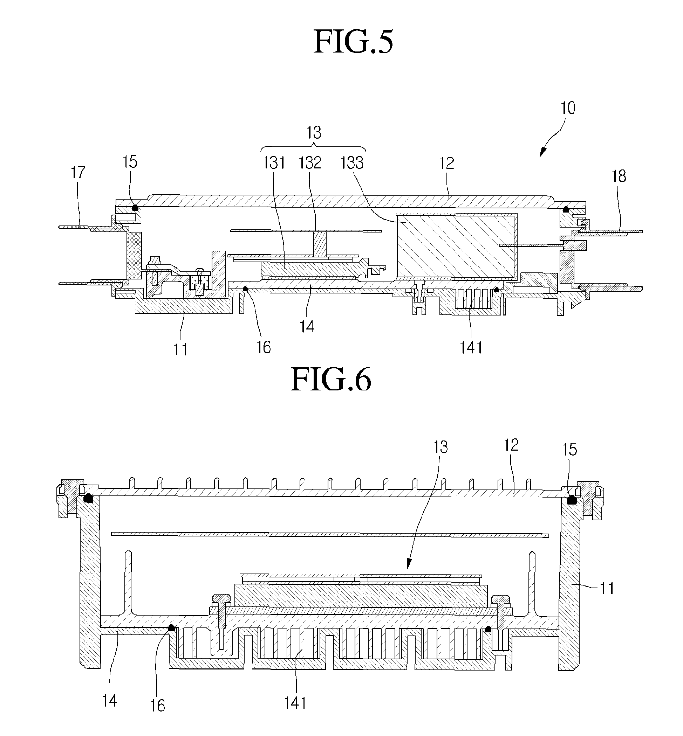

Fig. 2 is a perspective view of an outer appearance of an electronic component box according to an embodiment. Fig. 3 is an exploded perspective view of the electronic component box. Fig. 4 is a bottom view of a base cover disposed within the electronic component box. Fig. 5 is a cross-sectional view taken along line I-I' of Fig. 2. Fig. 6 is a cross-sectional view taken along line II-II' of Fig. 2.

Referring to Figs. 2 to 6, an electronic component box 10 according to the embodiment may include an inverter, LDC, or an on-board charger (OBC).

In detail, the electronic component box 10 includes a housing 11 defining an outer appearance thereof and having an opened top surface, a top cover 12 covering the opened top surface of the housing 11, a power-in connector 18 mounted on one surface of the housing 11, a power-out connecter 17 mounted on the other side of the housing 11, a signal connector 19, an electronic component set 13 accommodated within the housing 11, a base cover 14 on which the electronic component set 13 is seated, a first sealer 15 surrounded along contact surfaces of the top cover 12 and housing 11 to a waterproof function, and a second sealer 16 disposed between contact surfaces of the base cover 14 and the housing 11 to perform a waterproof function.

An in-connector hole 114 in which the power-in connector 18 is mounted is defined in one side surface of the housing 11. Also, an out-connector hole 116 in which the power-out connector 17 is mounted and a signal connector hole 115 in which the signal connector 19 is mounted are defined in the other side surface. The signal connector hole 115 may be defined in any one of one side surface and the other surface of the housing 11.

Also, a cooling passage 111 through which coolant flow is defined in a bottom surface of the housing 11 in a meander line shape. Also, a coolant inflow port 112 into which coolant is introduced and a coolant discharge port 113 through which the coolant is discharged are disposed on a side surface of the housing 11. The coolant inflow port 112 and the coolant discharge port 113 may respectively communicate with an inlet and outlet of the cooling passage 111. Thus, the coolant introduced through the coolant inflow port 112 flows along the cooling passage 111 to cool the electronic component set 13 seated on a top surface of the base cover 14. Here, the electronic components generating a relatively large amount of heat are disposed on a position close to the inlet of the cooling passage 111, and the electronic components generating a relatively small amount of heat are disposed on a position close to the outlet of the cooling passage 111 to improve heat exchange efficiency.

Also, the second sealer 16 is seated along an outer line of a top surface of the cooling passage 111, and the base cover 14 is seated on the second sealer 16 to prevent the coolant flowing along the cooling passage 111 from leaking toward the electronic component set 13. The first sealer 15 is seated along an edge of the top surface of the housing 111, and the top cover 12 is seated on the first sealer 15 to prevent water or foreign materials from being introduced into the housing 11 from the outside.

Also, as shown in Fig. 4, the base cover 14 includes a cover body 141 and a plurality of cooling pins 142. The cover body 141 covers the cooling passage 111, and the plurality of cooling pins protrude from on back surface of the cover body 141, particularly, a portion of a back surface corresponding to an inner space of the cooling passage 111. When the base cover 14 is seated, the plurality of cooling pins 142 may be rounded along a profile of the cooling passage 111. The plurality of cooling pins 142 are spaced a predetermined distance from each other to heat-exchange with the coolant flowing along the cooing passage through heat conduction. That is, heat generated from the electronic component set 13 may be transferred into the coolant through the plurality of cooling pins 142.

Also, the electronic component set 13 may include a switching device 131 including an insulated gate bipolar mode transistor (IGBT) that switches a DC voltage to output a three-phase current voltage, a DC link cap 133 mounted on a side of the top surface of the base cover 14 to stabilize an input voltage and reduce noises of the switching device 131, and a power PCB 132. In addition, the electronic component set 13 may further include various electronic components that are not described herein.

Each of the housing 11 and the top cover 12 may be formed of a light plastic material through plastic injection molding using a plastic resin. The housing 11 and the top cover 12 are formed of the plastic materials to decrease a weight thereof and improve price competiveness when compared to those formed of an existing iron or aluminum material. However, in the case where the housing 11 and the top cover 12 are formed of the plastic materials, electromagnetic waves generated from the electronic component set 13 may not be effectively shield.

To solve this limitation, an at least inner circumferential surface of the housing 11 and a back surface of the top cover 12 may be plated with nickel (Ni) or chromium (Cr). Since the plating process using the Ni or Cr is performed on the inner circumferential surface of the housing 11, the electromagnetic waves emitted from the electronic component set 13 may be effectively shielded. The plated layer may have a minimum thickness in a case where copper (Cu) is plated to a thickness of about 15 µm, nickel (Ni) is plated to a thickness of about 10 µm, and chromium (Cr) is to with a thickness of about 0.2 µm. On the other hand, the plated layer may have a maximum thickness in a case where copper (Cu) is plated to a thickness of about 20 µm, nickel (Ni) is plated to a thickness of about 15 µm, and chromium (Cr) is plated to a thickness of about 0.3 µm. The Cu, Ni, and Cr plated layers may be successively formed within a range of the maximum thickness and the minimum thickness.

In addition, in the case of the existing electronic component box, since the cooling passage and the cooling pin protrude from the outer bottom surface of the housing, and an opening of the bottom surface of the cooling path is covered by a separate bottom cover, the electronic component box has no choice but to increase a thickness thereof. Furthermore, the coolant leaks from the cooling passage, and thus other components of the vehicle may corrode with the coolant. However, according to the embodiment, the cooling passage 11 may be defined in the inner bottom surface of the housing, and the top surface of the cooling passage 111 may be covered by the base cover 14. When the electronic component 10 is mounted within the vehicle, the opened top surface of the cooling passage 111 faces an upper side to prevent the coolant from leaking through the top surface of the cooling passage.

Also, in the case of the existing electronic component, since the cooling passage is defined in the outer bottom surface of the housing, and a separate plate on which the electronic component is seated is seated on the inner bottom surface of the housing, cooling efficient may be reduced. However, according to the embodiment, since the base cover 14 is seated on the top surface of the cooling passage, and the electronic component set 13 is seated on the top surface of the cover base 14, the heat-exchange efficiency may increase. That is, if heat discharged from the electronic component set 13 passes through only the base cover 14, since the heat may directly heat-exchange with the coolant, the heat-exchange efficient may significantly increase when compared to a double bottom structure according to the related art.

Also, since the aluminum, the steel plate cold commercial (SPCC), or different kinds of metal plate which shields the electromagnetic waves and has high heat conductivity is applied as the material of the base cover 14, it is not necessary to perform a separate plating process onto the bottom portion of the housing 11 covered by the base cover 14. Thus, the plating processing costs may be reduced.

The above-described the electronic component box according to the embodiments may have following effects.

First, since the portion of the electronic component is formed of the plastic material through the plastic injection molding, the electronic component box may decrease in self-weight.

Second, since nickel (Ni) or chromium (Cr) is plated on the surface of the electronic component to shield the electromagnetic waves, the electromagnet shielding function may be maintained or further improved.

Third, the cooling passage may be defined within the housing of the electronic component box to decrease the thickness of the electronic component box. In addition, the leakage of the coolant to the outside of the electronic component box may be prevented to reduce possibility of corrosion or electrical short-circuit of other components of the vehicle.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. An electronic component box for a vehicle, the electronic component box comprising:
a housing formed of a plastic material and manufactured through plastic injection molding, the housing having an opened top surface;
a top cover formed of a plastic material and manufactured through the plastic injection molding, the top cover covering the opened top surface of the housing;
a base cover seated on a bottom surface of the housing;
an electronic component set seated on a top surface of the base cover; and
a plated layer disposed on an inner circumferential surface of the housing and a back surface of the top cover to shield an electromagnetic wave.

2. The electronic component box according to claim 1, wherein the plated layer comprises a metal plated layer in which a copper (Cu) plated layer is coated with one or all of chromium (Cr) and nickel (Ni).

3. The electronic component box according to claim 2, wherein the copper (Cu) plated layer has a thickness ranging from about 15 µm to about 20 µm.

4. The electronic component box according to claim 3, wherein the chromium (Cr) plated layer has a thickness ranging from about 0.2 µm to about 0.3 µm.

5. The electronic component box according to claim 2, wherein the nickel (Ni) plated layer has a thickness ranging from about 10 µm to about 15 µm.

6. The electronic component box according to claim 5, wherein the chromium (Cr) plated layer has a thickness ranging from about 0.2 µm to about 0.3 µm.

7. The electronic component box according to claim 1, wherein a cooling passage having a predetermined depth and an opened top surface is defined in an inner bottom surface of the housing, and
the opened top surface of cooling passage is covered by the base cover.

8. The electronic component box according to claim 7, wherein the base cover comprises a metal plate having high heat conductivity and formed of aluminum or iron.

9. The electronic component box according to claim 8, wherein the base cover comprises:
a cover body covering the cooling passage; and
a plurality of cooling pins protruding from a bottom surface of the cover body and placed on the cooling passage.

10. The electronic component box according to claim 7, further comprising a sealer disposed along an outer line of the cooling passage and pressed by the base cover.

11. The electronic component box according to claim 1, further comprising a sealer disposed along an edge of the housing and pressed by the top cover.
